# EUROPEAN PATENT APPLICATION

(11) **EP 4 718 502 A1**
(43) Date of publication of application: **01.04.2026**
(21) Application number: 24829950.5
(22) Date of filing: 11.03.2024
(51) Int. Cl.: H01L 23/488, H01L 21/48, H01L 23/498, H01L 23/12

(54) **CHIP PACKAGING STRUCTURE AND MANUFACTURING METHOD THEREFOR, AND ELECTRONIC DEVICE**

(30) Priority: 27.06.2023 CN 202310770847
(71) Applicant: Huawei Technologies Co., Ltd., Shenzhen, Guangdong 518129 (CN)
(72) Inventor: HUANG, Chao, Shenzhen, Guangdong 518129 (CN); XIAO, Hongyuan, Shenzhen, Guangdong 518129 (CN); TAO, Junlei, Shenzhen, Guangdong 518129 (CN)
(74) Representative: Gill Jennings & Every LLP
(86) International application number: PCT/CN2024/081030
(87) International publication number: WO 2025/001297

(57) **Abstract**

This application provides a chip packaging structure and a preparation method thereof, and an electronic device, and relates to the field of chip technologies. A redistribution layer used in the chip packaging structure can support subsequent evolution for smaller vias. The chip packaging structure includes a redistribution layer, and the redistribution layer includes a first copper pillar layer, a second copper pillar layer, and a metal routing layer. The first copper pillar layer includes a plurality of first copper pillars, and the second copper pillar layer includes a plurality of second copper pillars. The metal routing layer is located between the first copper pillar layer and the second copper pillar layer, and the metal routing layer is electrically connected to the plurality of first copper pillars and the plurality of second copper pillars. The plurality of first copper pillars and the plurality of second copper pillars are of upright pillar structures. The plurality of first copper pillars are coplanar on a side close to the metal routing layer, and the plurality of second copper pillars are coplanar on a side away from the metal routing layer.

## Description

This application claims priority to Chinese Patent Application No. 202310770847.7, filed with the China National Intellectual Property Administration on June 27, 2023 and entitled "CHIP PACKAGING STRUCTURE AND PREPARATION METHOD THEREOF, AND ELECTRONIC DEVICE", which is incorporated herein by reference in its entirety.

### TECHNICAL FIELD

This application relates to the field of chip technologies, and in particular, to a chip packaging structure and a preparation method thereof, and an electronic device.

### BACKGROUND

A redistribution layer (redistribution layer, RDL) is a critical part for fan-out wafer-level packaging (fan out wafer level packaging, FOWLP), and contributes to electrical extension and interconnection in an XY plane. In the RDL, a metal layer and a dielectric layer are deposited, forming a corresponding metal routing pattern, to redistribute I/O (input/output) ports of a chip to a new region with more flexible pitches.

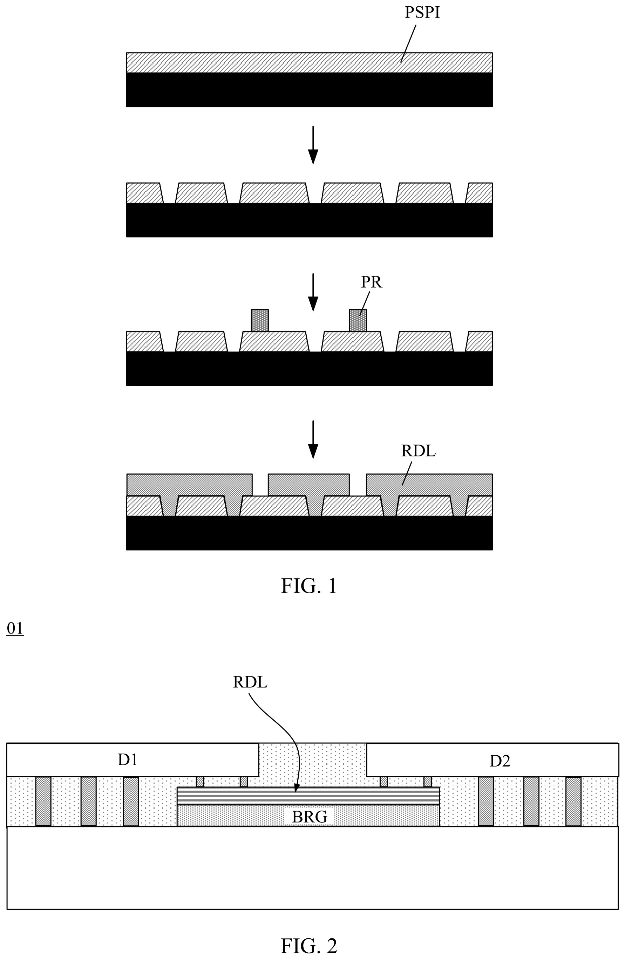

In an existing FOWLP process, as shown in FIG. 1, a silicon wafer is first coated with photosensitive polyimide (photosensitive polyimide, PSPI), and then the applied PSPI is subjected to photoetching and development to form vias (via). Next, a PR (photoresist, photoresist) is applied and subjected to photoetching and development, followed by electroplating with copper to form an RDL. The RDL is prepared based on the interlayer dielectric material PSPI (that is, PI-RDL), and is frequently affected by production line variations during preparation, causing problems such as poor morphology of vias (via) or photoresist residues on vias, resulting in a yield loss and a reliability risk. During fine-pitch (fine pitch) evolution of advanced fan-out packaging, increasing interconnection density requires an increasingly high capability of PSPI for vias. Therefore, to resolve the foregoing problems, it is urgent to provide a new preparation process for fan-out packaging, to continuously support subsequent evolution for smaller vias.

### SUMMARY

This application provides a chip packaging structure and a preparation method thereof, and an electronic device. A redistribution layer used in the chip packaging structure can support subsequent evolution for smaller vias.

This application provides a chip packaging structure. The chip packaging structure includes a redistribution layer, and the redistribution layer includes a first copper pillar layer, a second copper pillar layer, and a metal routing layer. The first copper pillar layer includes a plurality of first copper pillars, and the second copper pillar layer includes a plurality of second copper pillars. The metal routing layer is located between the first copper pillar layer and the second copper pillar layer, and the metal routing layer is electrically connected to the plurality of first copper pillars and the plurality of second copper pillars. The plurality of first copper pillars and the plurality of second copper pillars are of upright pillar structures. The plurality of first copper pillars are coplanar on a side close to the metal routing layer, and the plurality of second copper pillars are coplanar on a side away from the metal routing layer.

In this application, the first copper pillars and the second copper pillars can be separately prepared based on development and exposure with a photoresist. The first copper pillars and the second copper pillars that are of upright pillar structures are formed based on good photosensitivity of the photoresist, allowing the first copper pillars and the second copper pillars to be smaller in size and pitch, so that subsequent evolution for smaller vias can be supported, to meet a requirement of the chip packaging structure for high interconnection density. In addition, after the first copper pillars and the second copper pillars are prepared, surfaces of the first copper pillar layer and the second copper pillar layer can be separately ground through chemical mechanical planarization (chemical mechanical planarization, CMP) to form flat interfaces, so that upper surfaces of the plurality of first copper pillars are coplanar, and upper surfaces of the plurality of second copper pillars are coplanar, providing more excellent coplanarity (coplanarity, COP), thereby facilitating a connection between the redistribution layer and another component.

In some possible implementations, the first copper pillar layer is embedded in a first dielectric layer, and the second copper pillar layer and the metal routing layer are embedded in a second dielectric layer.

In some possible implementations, the first dielectric layer includes one or more of photosensitive polyimide PSPI, polyimide PI, photosensitive polybenzoxazole PSPBO, polybenzoxazole PSPBO, photosensitive benzocyclobutene PSBCB, benzocyclobutene PSBCB, SiO₂, Si₃N₄, SiN, SiON, phosphosilicate glass PSG, and borophosphosilicate glass BPSG.

In some possible implementations, the second dielectric layer includes one or more of photosensitive polyimide PSPI, polyimide PI, photosensitive polybenzoxazole PSPBO, polybenzoxazole PSPBO, photosensitive benzocyclobutene PSBCB, benzocyclobutene PSBCB, SiO₂, Si₃N₄, SiN, SiON, phosphosilicate glass PSG, and borophosphosilicate glass BPSG.

In some possible implementations, the redistribution layer further includes a plurality of bond pads; and the plurality of bond pads are located on a side that is of the second copper pillar layer and that is away from the metal routing layer, and the plurality of bond pads are respectively electrically connected to the plurality of second copper pillars.

This application further provides a method for preparing a chip packaging structure. The preparation method may include: performing development and exposure on a photoresist material to prepare a plurality of first copper pillars; preparing a first dielectric layer to cover the plurality of first copper pillars, and performing grinding to expose the plurality of first copper pillars; performing development and exposure on a photoresist material to prepare a metal routing layer connected to the plurality of first copper pillars; performing development and exposure on a photoresist material to prepare a plurality of second copper pillars connected to the metal routing layer; and preparing a second dielectric layer to cover the metal routing layer and the plurality of second copper pillars, and performing grinding to expose the plurality of second copper pillars.

In some possible implementations, after preparing the second dielectric layer to cover the metal routing layer and the plurality of second copper pillar, and performing grinding to expose the plurality of second copper pillars, the preparation method further includes: performing development and exposure on a photoresist material to prepare a plurality of bond pads respectively connected to the plurality of second copper pillars.

In some possible implementations, preparing the first dielectric layer to cover the plurality of first copper pillars includes: applying polyimide to form the first dielectric layer for covering the plurality of first copper pillars.

In some possible implementations, preparing the second dielectric layer to cover the metal routing layer and the plurality of second copper pillars includes: applying polyimide to form the second dielectric layer for covering the metal routing layer and the plurality of second copper pillars.

In some possible implementations, the plurality of first copper pillars, the metal routing layer, and the plurality of second copper pillars are all prepared by using an electroplating process.

This application further provides an electronic device. The electronic device includes a circuit board and the chip packaging structure provided in any one of the foregoing possible implementations, where the chip packaging structure is electrically connected to the circuit board.

### BRIEF DESCRIPTION OF DRAWINGS

FIG. 1 shows a process of preparing an RDL in the conventional technology;
FIG. 2 is a diagram of a structure of a chip packaging structure according to an embodiment of this application;
FIG. 3 is a diagram of a structure of an RDL according to an embodiment of this application;
FIG. 4 is a diagram of a partial structure of an RDL according to the conventional technology and a partial structure of an RDL according to an embodiment of this application;
FIG. 5 is a flowchart of a method for preparing a chip packaging structure according to an embodiment of this application;
FIG. 6 is a diagram of a structure of an RDL in a preparation process according to an embodiment of this application;
FIG. 7 is a diagram of a structure of an RDL in a preparation process according to an embodiment of this application;
FIG. 8 is a diagram of a structure of an RDL in a preparation process according to an embodiment of this application;
FIG. 9 is a diagram of a structure of an RDL in a preparation process according to an embodiment of this application;
FIG. 10 is a diagram of a structure of an RDL in a preparation process according to an embodiment of this application; and
FIG. 11 is a diagram of a structure of an RDL in a preparation process according to an embodiment of this application.

### DESCRIPTION OF EMBODIMENTS

To make objectives, technical solutions, and advantages of this application clearer, the following clearly and completely describes the technical solutions in this application with reference to accompanying drawings in this application. It is clear that the described embodiments are some rather than all of embodiments of this application. All other embodiments obtained by a person of ordinary skill in the art based on embodiments of this application without creative efforts shall fall within the protection scope of this application.

In the specification, embodiments, claims, and accompanying drawings of this application, the terms "first", "second", and the like are merely intended for distinguishing and description, and shall not be understood as indicating or implying relative importance, or indicating or implying a sequence. The term "and/or" is used for describing an association relationship between associated objects, and indicates that three relationships may exist. For example, "A and/or B" may indicate the following three cases: Only A exists, only B exists, and both A and B exist, where A and B may be singular or plural. The character "/" usually indicates an "or" relationship between associated objects. "At least one (item)" means one or more, and "a plurality of" means two or more. "Mounting", "connection", "interconnection", and the like should be understood in a broad sense, for example, may be an electrical connection or a mechanical connection; may be a fixed connection, a detachable connection, or an integrated connection; or may be a direct connection, an indirect connection through an intermediate medium, or communication between interiors of two elements. In addition, the terms "include", "have", and any variant thereof are intended to cover non-exclusive inclusion, for example, include a series of steps or units. A method, system, product, or device is not necessarily limited to those steps or units expressly listed, but may include other steps or units not expressly listed or inherent to such a process, method, product, or device. "Up", "down", "left", "right", and the like are used only relative to the orientation of the components in the accompanying drawings. These directional terms are relative concepts, are used for relative descriptions and clarifications, and may vary accordingly as positions at which the components in the accompanying drawings are placed change.

An embodiment of this application provides an electronic device. The electronic device includes a circuit board (printed circuit board, PCB; also referred to as a printed circuit board) and a chip packaging structure electrically connected to the circuit board.

For example, fan-out packaging (FOP) with a redistribution layer (RDL) may be applied to the chip packaging structure. In this application, a new preparation process is applied for the redistribution layer (RDL), avoiding photoetching and exposure on photosensitive polyimide, and meeting preparation requirements only based on a capability of a photoresist (photosensitive, PR) for photoetching. In this case, a via (via) formed through photoetching and exposure is limited only by the photoresist. Because the photoresist is better than the photosensitive polyimide in photosensitivity, a smaller via (via) can be obtained, and therefore subsequent evolution for smaller vias can be supported.

A configuration form of the electronic device is not limited in this application. For example, the electronic device may be a mobile phone, a tablet computer, a notebook computer, a vehicle-mounted computer, a smartwatch, a smart band, a server, or another electronic product.

Any fan-out packaging (FOP) with a redistribution layer may be applied to the chip packaging structure provided in embodiments of this application. A package form of the chip packaging structure is not limited in this application.

For example, as shown in FIG. 2, in some possible implementations, a chip packaging structure 01 provided in an embodiment of this application includes a bridge die BRG (bridge die) and a plurality of dies (D1 and D2), and a redistribution layer (RDL) is provided on a surface of the bridge chip BRG. In this case, the bridge die BRG (bridge) and the plurality of dies (D1 and D2) are interconnected by the redistribution layer (RDL).

The RDL provided on the bridge die BRG is used as an example to describe a specific configuration of an RDL provided in embodiments of this application.

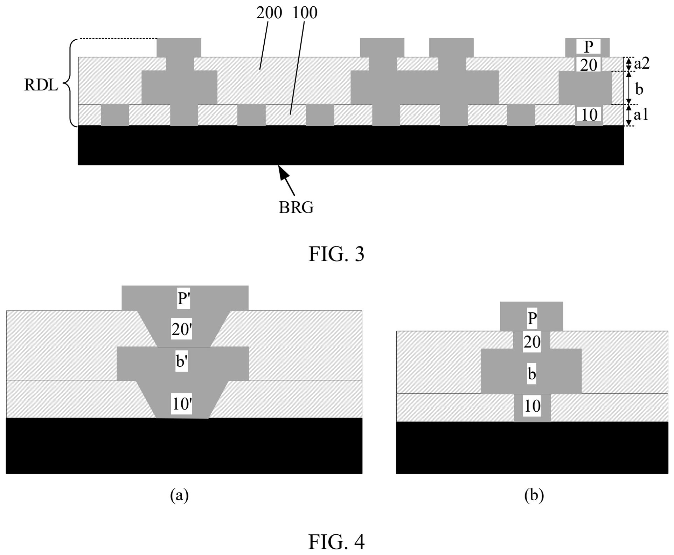

For example, as shown in FIG. 3, an embodiment of this application provides an RDL. The RDL may include a first copper pillar layer a1, a second copper pillar layer a2, and a metal routing layer b. The first copper pillar layer a1 includes a plurality of first copper pillars 10, and the second copper pillar layer a2 includes a plurality of second copper pillars 20. The metal routing layer b is located between the first copper pillar layer a1 and the second copper pillar layer a2, and the metal routing layer b is electrically connected to the plurality of first copper pillars 10 below and electrically connected to the plurality of second copper pillars 20 above. The metal routing layer b is electrically connected to the bridge die BRG below by the plurality of first copper pillars 10, and the metal routing layer b is electrically connected to the dies (D1 and D2) above by the plurality of second copper pillars 20. In this way, I/O ports on a surface of the bridge die BRG are redistributed through the RDL.

Based on an actual requirement, a plurality of metal routing layers b may be provided in the RDL, and adjacent metal routing layers b are connected by copper pillars. In FIG. 2, only one metal routing layer b is used as an example for description.

Certainly, to ensure a bonding connection between the RDL and the dies (D1 and D2), as shown in FIG. 3, a bond pad P (pad) may be provided on a surface of the RDL, so that the RDL is electrically connected to the dies (D1 and D2) by the bond pad P (pad). For example, in some possible implementations, a plurality of bond pads P may be provided on the plurality of second copper pillars 20, the plurality of second copper pillars 20 are respectively connected to different bond pads P, and the metal routing layer b is electrically connected to the bond pads P by the second copper pillars 20.

With reference to an RDL prepared based on photosensitive polyimide (PSPI) in the conventional technology, the following describes, through comparison, a structure of an RDL prepared based on a photoresist material in embodiments of this application.

In FIG. 4, (a) is a diagram of a partial structure of an RDL prepared by using a process (PI-RDL) in FIG. 1 in the conventional technology, and (b) is a diagram of a partial structure of the RDL shown in FIG. 3.

As shown in FIG. 1 and (a) in FIG. 4, in the RDL prepared based on photosensitive polyimide (PSPI) in the conventional technology, a via formed after development and exposure are performed on a PSPI material is in an inverted trapezoidal shape, and consequently, a metal structure formed in the via is of a neck-down structure that is wider at the top and narrower at the bottom. The existing RDL is prepared by implementing the process twice. A metal routing layer b' and a neck-down structure 10' below are prepared in one same process, so that the metal routing layer b' and the neck-down structure 10' are an integrated structure. A bond pad P' and a neck-down structure 20' below are prepared in one same process, so that the bond pad P' and the neck-down structure 20' are an integrated structure. In addition, the processes require a single seed layer. Therefore, there is an apparent interface between the metal routing layer b' and the neck-down structure 20' above.

In contrast, as shown in (b) in FIG. 4, in the RDL provided in this application, photosensitive polyimide (PSPI) is not required, and the first copper pillar 10, the second copper pillar 20, and the bond pad P are separately prepared based on development and exposure on a photoresist. Because the photoresist is better than PSPI in photosensitivity, a via (via) formed after development and exposure are performed on the photoresist can be smaller, and the via has a vertical side wall (that is, the side wall is perpendicular to a bottom). In this case, the via is rectangular or nearly rectangular. Correspondingly, the first copper pillar 10 and the second copper pillar 20 that are formed in the vias are of upright pillar structures, allowing the copper pillars (10 and 20) to be smaller in size and pitch. In other words, the RDL is prepared by directly performing development and exposure based on the photoresist, so that subsequent evolution for smaller vias can be supported, to meet a requirement of the chip packaging structure for high interconnection density.

As shown in FIG. 4, compared with the neck-down structures (10' and 20') where upper and lower end surfaces differ in size (the upper end surface is larger than the lower end surface), and a side surface is not perpendicular to the upper and lower end surfaces (that is, the side surface is inclined), the first copper pillar 10 and the second copper pillar 20 in this application are of upright pillar structures where upper and lower end surfaces are substantially the same in size, and a side surface (namely, a generatrix of the pillar) is nearly perpendicular to the upper and lower end surfaces. Certainly, due to a certain deviation in the preparation process, in an actual product, the side surfaces of the copper pillars (10 and 20) may have some dents, and therefore are nearly perpendicular to, not absolutely perpendicular to, the upper and lower end surfaces. Similarly, the upper and lower end surfaces may also have certain deviations due to the process, and in this case, sizes of the two end surfaces are nearly the same, but not completely the same.

In other words, in this application, the first copper pillar 10 and the second copper pillar 20 that are of upright pillar structures have uniform thickness, where shapes and sizes of the upper and lower end surfaces are substantially the same.

For example, in some possible implementations, the first copper pillar 10 and the second copper pillar 20 may be of cylindrical structures (or nearly cylindrical structures), cuboid structures, or the like. The following embodiments are all described by using an example in which the first copper pillar 10 and the second copper pillar 20 are of cylindrical structures.

It should be noted herein that a shape of the via (via) in this application, for example, rectangular or inverted trapezoidal, is a cross-sectional shape of the via (via) in a longitudinal direction (that is, a radial direction of a through hole).

In addition, in this application, after the first copper pillars 10 and the second copper pillars 20 are prepared separately based on development and exposure on the photoresist, surfaces of the first copper pillar layer a1 and the second copper pillar layer b1 can be separately ground through chemical mechanical planarization (chemical mechanical planarization, CMP) to form flat interfaces, so that upper surfaces (that is, the surfaces close to a side of the metal routing layer b) of the plurality of first copper pillars 10 are coplanar, and upper surfaces (that is, the surfaces away from a side of the metal routing layer b) of the plurality of second copper pillars 20 are coplanar, providing more excellent coplanarity (coplanarity, COP), thereby facilitating subsequent soldering.

In some possible implementations, the first copper pillar layer a1 is embedded in a first dielectric layer 100, and the metal routing layer b and the second copper pillar layer a2 are embedded in a second dielectric layer 200. For details, refer to a preparation method as follows.

Dielectric materials for the first dielectric layer 100 and the second dielectric layer 200 are not limited in this application, provided that an actual requirement of the RDL is met.

It should be understood that PSPI is used for a dielectric layer in the conventional technology. Because a photosensitive group significantly reduces material characteristics of PI, in some application scenarios, to meet a requirement of a component for electrical performance, a PSPI dielectric layer with a large thickness is required, and consequently the RDL is prone to warpage (warpage).

However, in this application, the dielectric layers (100 and 200) are not limited to PSPI, and have a larger selection range. In practice, more PI materials and non-PI materials (for example, inorganic dielectric materials) with better properties may be selected based on specific requirements. Thicknesses of the dielectric layers (100 and 200) may be reduced as long as a requirement of a component for electrical performance is met.

For example, in some possible implementations, a PI material with a lower coefficient of thermal expansion (coefficient of thermal expansion, CET) may be selected for the dielectric layers (100 and 200), and the thickness of the dielectric layer is reduced through grinding, to reduce a probability of warpage (warpage) of the RDL.

For example, in some possible implementations, the first dielectric layer 100 includes one or more of photosensitive polyimide (PSPI), polyimide (PI), photosensitive polybenzoxazole PSPBO (photosensitive polybenzoxazole, PBO), polybenzoxazole (polybenzoxazole, PBO), photosensitive benzocyclobutene (photosensitive benzocyclobutene, PSBCB), benzocyclobutene (benzocyclobutene, BCB), SiO₂, Si₃N₄, SiN, SiON, phosphosilicate glass (phospho silicate glass, PSG), and borophosphosilicate glass (boro-phospho-silicate glass, BPSG).

For example, in some possible implementations, the second dielectric layer 200 includes one or more of photosensitive polyimide (PSPI), polyimide (PI), photosensitive polybenzoxazole (PSPBO), polybenzoxazole (PSPBO), photosensitive benzocyclobutene (PSBCB), benzocyclobutene (PSBCB), SiO₂, Si₃N₄, SiN, SiON, phosphosilicate glass (PSG), and borophosphosilicate glass (BPSG).

In addition, materials of the first dielectric layer 100 and the second dielectric layer 200 may be the same or may be different. This is not limited in this application. For example, in some possible implementations, a same PI material may be used for the first dielectric layer 100 and the second dielectric layer 200.

The following further describes, with reference to a method for preparing a chip packaging structure, the redistribution layer (RDL) provided in embodiments of this application.

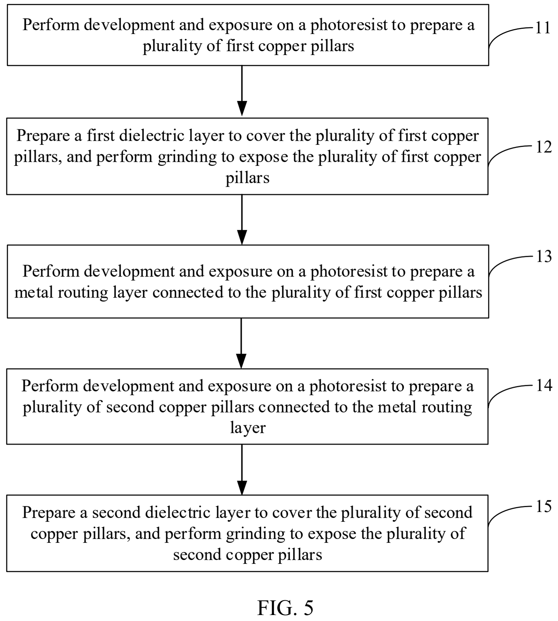

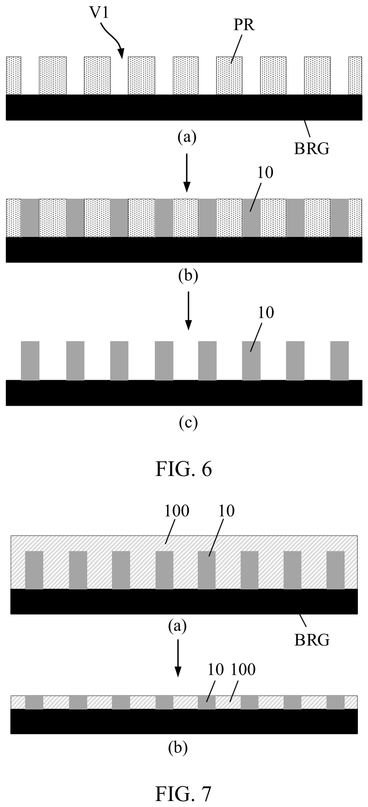

For example, an embodiment of this application provides a method for preparing a chip packaging structure. As shown in FIG. 5, the preparation method includes
Step 11: As shown in FIG. 6, perform development and exposure on a photoresist (PR) to prepare a plurality of first copper pillars 10.

For example, in some possible implementations, as shown in (a) in FIG. 6, the PR may be first applied to a bridge die BRG (which may be a wafer or a single wafer). Then, as shown in (b) in FIG. 6, development and exposure are performed on the PR to form a plurality of vias V1, and the first copper pillars 10 are formed respectively in the plurality of vias V1 by using an electroplating process, to form a first copper pillar layer. Finally, as shown in (c) in FIG. 6, the remaining PR is removed.

In step 11, the plurality of first copper pillars 10 are prepared based on development and exposure on the photoresist (PR). Because the photoresist has good photosensitivity, the vias V1 can be formed into a rectangular or nearly rectangular shape, and the vias V1 can be smaller in size and pitch. Correspondingly, the first copper pillars 10 of upright pillar structures (for example, cylinders) that are formed in the plurality of vias V1 are smaller in size and pitch.

Step 12: As shown in FIG. 7, prepare a first dielectric layer 100 to cover the plurality of first copper pillars 10, and perform grinding to expose the plurality of first copper pillars 10.

For example, in some possible implementations, as shown in (a) in FIG. 7, PI is applied to a surface of the bridge die BRG with the plurality of first copper pillars 10 formed, to form the first dielectric layer 100. Then, as shown in (b) in FIG. 7, the first dielectric layer 100 is ground by using a CMP process to expose the first copper pillars 10. In this case, upper surfaces of the plurality of first copper pillars 10 are located in a same plane (that is, coplanar), and an upper surface of the first dielectric layer 100 has good flatness.

In practice, in some possible implementations, the first dielectric layer 100 may be ground to a small thickness through step 12 as required, reducing heights of the first copper pillars 10, to reduce a thickness of the entire RDL, thereby reducing a probability of warpage of the RDL.

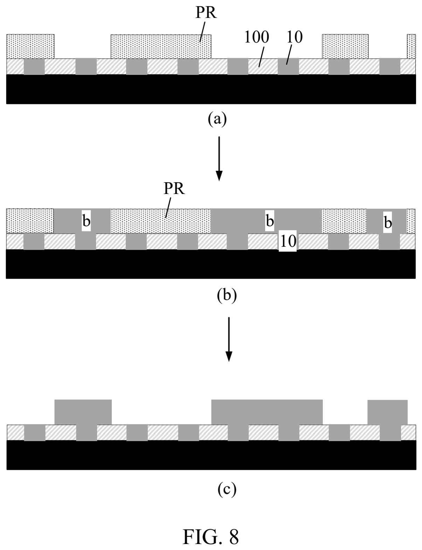

Step 13: As shown in FIG. 8, perform development and exposure on a photoresist (PR) to prepare a metal routing layer b connected to the plurality of first copper pillars 10.

For example, in some possible implementations, step 13 may include: As shown in (a) in FIG. 8, the PR is applied to the first dielectric layer 100. Then, as shown in (b) in FIG. 8, development and exposure are performed on the PR to form vias, and the metal routing layer b is formed in the PR vias by using an electroplating process. Next, as shown in (c) in FIG. 8, the remaining PR is removed.

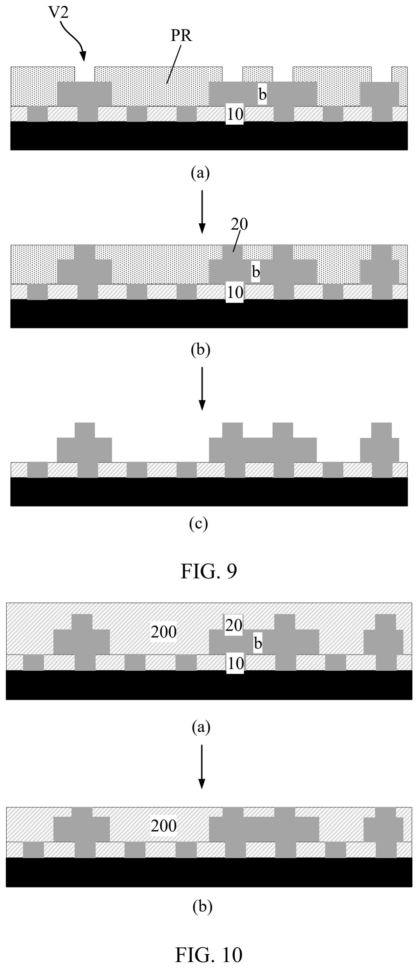

Step 14: As shown in FIG. 9, perform development and exposure on a photoresist (PR) to prepare a plurality of second copper pillars 20 connected to the metal routing layer b.

For example, in some possible implementations, step 14 may include: As shown in (a) in FIG. 9, the PR is first applied to the metal routing layer b. Then, as shown in (b) in FIG. 9, development and exposure are performed on the PR to form a plurality of vias V2, and the second copper pillars 20 are formed respectively in the plurality of vias V2 by using an electroplating process, to form a second copper pillar layer. Next, as shown in (c) in FIG. 9, the remaining PR is removed.

Similar to the plurality of first copper pillars 10 formed in step 11, the plurality of second copper pillars 20 prepared based on development and exposure on the photoresist (PR) are of upright pillar structures (for example, cylinders), and the plurality of second copper pillars are small in size and pitch. For details, refer to the foregoing related descriptions.

Step 15: As shown in FIG. 10, prepare a second dielectric layer 200 to cover the metal routing layer b and the plurality of second copper pillars 20, and perform grinding to expose the plurality of second copper pillars 20.

For example, in some possible implementations, as shown in (a) in FIG. 10, after the second copper pillars 20 are completed, PI is applied to form the second dielectric layer 200. Then, as shown in (b) in FIG. 10, the second dielectric layer 200 is ground by using a CMP process to expose the second copper pillars 20. In this case, upper surfaces of the plurality of second copper pillars 20 are located in a same plane (that is, coplanar), and an upper surface of the second dielectric layer 200 has good flatness.

In some possible implementations, the second dielectric layer 200 may be ground to a small thickness through step 15 based on an actual requirement, reducing heights of the second copper pillars 20, to reduce a thickness of the entire RDL, thereby reducing a probability of warpage of the RDL.

It should be understood herein that, when different materials are used for the first dielectric layer 100 and the second dielectric layer 200, a flat interface is formed between the first dielectric layer 100 and the second dielectric layer 200.

According to an actual requirement, after step 15, a metal routing layer and a copper pillar layer may still be prepared to form an RDL with a plurality of metal routing layers.

To implement a connection between the RDL and an external component, a bond pad may be prepared at the end of the preparation process.

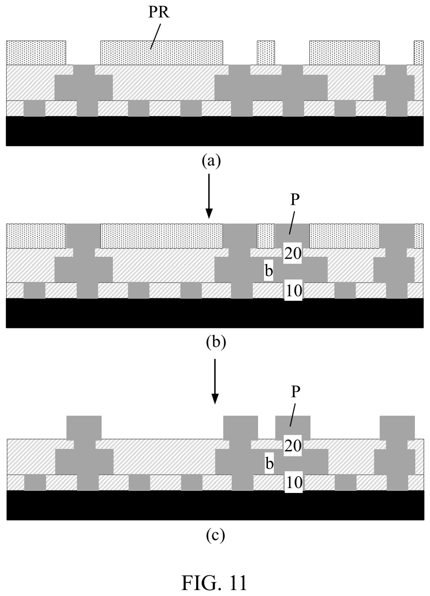

For example, as shown in FIG. 11, after step 15, development and exposure may be performed on PR to prepare a plurality of bond pads P respectively connected to the plurality of second copper pillars 20.

For example, in some possible implementations, as shown in (a) in FIG. 11, the PR may be applied to the second dielectric layer 200. Then, as shown in (b) in FIG. 11, development and exposure are performed on the PR to form a plurality of vias to expose the second copper pillars 20, and the bond pads P connected to the second copper pillars 20 are formed in the vias by using an electroplating process. Finally, as shown in (c) in FIG. 11, the remaining PR is removed.

It should be noted that the photoresist in embodiments of this application may alternatively be replaced with another photoresist material, for example, a photoresist dry film. This is not specifically limited in this application, provided that preparation of the RDL can be implemented.

It should be understood that, in various embodiments of this application, sequence numbers of the foregoing preparation processes do not mean an execution sequence. The execution sequence of the preparation processes should be determined based on specific functions and internal logic of components, and should not be construed as any limitation on the implementation processes of embodiments of this application.

In addition, for other related content in the foregoing preparation method, reference may be made to a corresponding part in the foregoing structure embodiments, and details are not described herein again; and for another provided structure in the foregoing structure embodiments, reference may be made to the foregoing preparation method and a related preparation method for adjustment, and details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip packaging structure, comprising a redistribution layer, wherein
The redistribution layer comprises a first copper pillar layer, a second copper pillar layer, and a metal routing layer;
the first copper pillar layer comprises a plurality of first copper pillars, and the second copper pillar layer comprises a plurality of second copper pillars;
the metal routing layer is located between the first copper pillar layer and the second copper pillar layer, and the metal routing layer is electrically connected to the plurality of first copper pillars and the plurality of second copper pillars;
the plurality of first copper pillars and the plurality of second copper pillars are of upright pillar structures; and
the plurality of first copper pillars are coplanar on a side close to the metal routing layer, and the plurality of second copper pillars are coplanar on a side away from the metal routing layer.

2. The chip packaging structure according to claim 1, wherein
the first copper pillar layer is embedded in a first dielectric layer, and the second copper pillar layer and the metal routing layer are embedded in a second dielectric layer.

3. The chip packaging structure according to claim 2, wherein
the first dielectric layer comprises one or more of photosensitive polyimide, polyimide, photosensitive polybenzoxazole, polybenzoxazole, photosensitive benzocyclobutene, benzocyclobutene, SiO₂, Si₃N₄, SiN, SiON, phosphosilicate glass, and borophosphosilicate glass.

4. The chip packaging structure according to claim 2 or 3, wherein
the second dielectric layer comprises one or more of photosensitive polyimide, polyimide, photosensitive polybenzoxazole, polybenzoxazole, photosensitive benzocyclobutene, benzocyclobutene, SiO₂, Si₃N₄, SiN, SiON, phosphosilicate glass, and borophosphosilicate glass.

5. The chip packaging structure according to any one of claims 1 to 4, wherein
the redistribution layer further comprises a plurality of bond pads; and
the plurality of bond pads are located on a side that is of the second copper pillar layer and that is away from the metal routing layer, and the plurality of bond pads are respectively connected to the plurality of second copper pillars.

6. A method for preparing a chip packaging structure, comprising:
performing development and exposure on a photoresist material to prepare a plurality of first copper pillars;
preparing a first dielectric layer to cover the plurality of first copper pillars, and performing grinding to expose the plurality of first copper pillars;
performing development and exposure on a photoresist material to prepare a metal routing layer connected to the plurality of first copper pillars;
performing development and exposure on a photoresist material to prepare a plurality of second copper pillars connected to the metal routing layer; and
preparing a second dielectric layer to cover the metal routing layer and the plurality of second copper pillars, and performing grinding to expose the plurality of second copper pillars.

7. The method for preparing the chip packaging structure according to claim 6, wherein
after preparing the second dielectric layer to cover the metal routing layer and the plurality of second copper pillar, and performing grinding to expose the plurality of second copper pillars, the method further comprises:
performing development and exposure on a photoresist material to prepare a plurality of bond pads respectively connected to the plurality of second copper pillars.

8. The method for preparing the chip packaging structure according to claim 6 or 7, wherein
preparing the first dielectric layer to cover the plurality of first copper pillars comprises: applying polyimide to form the first dielectric layer for covering the plurality of first copper pillars; and
preparing the second dielectric layer to cover the metal routing layer and the plurality of second copper pillars comprises: applying polyimide to form the second dielectric layer for covering the metal routing layer and the plurality of second copper pillars.

9. The method for preparing the chip packaging structure according to any one of claims 6 to 8, wherein
the plurality of first copper pillars, the metal routing layer, and the plurality of second copper pillars are all prepared by using an electroplating process.

10. An electronic device, comprising a circuit board and the chip packaging structure according to any one of claims 1 to 5, wherein the chip packaging structure is electrically connected to the circuit board.
